# EUROPEAN PATENT APPLICATION

(11) **EP 4 080 764 A1**
(43) Date of publication of application: **26.10.2022**
(21) Application number: 20903387.7
(22) Date of filing: 06.05.2020
(51) Int. Cl.: H03H 9/02

(54) **BULK ACOUSTIC RESONATOR HAVING ELECTRODE HAVING GAP LAYER AND TEMPERATURE COMPENSATION LAYER, FILTER, AND ELECTRONIC APPARATUS**

(30) Priority: 16.12.2019 CN 201911293449
(71) Applicant: Rofs Microsystem (Tianjin) Co., Ltd, Tianjin 300462 (CN)
(72) Inventor: PANG, Wei, Tianjin 300072 (CN); HAO, Long, Tianjin 300072 (CN); XU, Yang, Tianjin 300072 (CN); YANG, Qingrui, Tianjin 300072 (CN); ZHANG, Menglun, Tianjin 300072 (CN)
(74) Representative: Bandpay & Greuter
(86) International application number: PCT/CN2020/088667
(87) International publication number: WO 2021/120499

(57) **Abstract**

The present invention relates to a bulk acoustic resonator, including: a substrate; an acoustic mirror; a bottom electrode; a top electrode; and a piezoelectric layer disposed between the bottom electrode and the top electrode, wherein the bottom electrode and/or the top electrode is a gap electrode having at least one gap layer, and in a thickness direction of the gap electrode, the gap layer remains at a distance from each of a top surface and a bottom surface of the gap electrode; and a temperature compensation layer made of a material having a temperature coefficient opposite to a temperature coefficient of a material used to form the piezoelectric layer, the temperature compensation layer being provided in a sandwich structure of the resonator composed of the bottom electrode, the piezoelectric layer and the top electrode. The present invention further relates to a filter having the above resonator and an electronic apparatus having the filter or the resonator.

## Description

### TECHNICAL FIELD

Embodiments of the present disclosure relate to the field of semiconductors, in particular, to a bulk acoustic wave resonator, a filter having the resonator, and an electronic device having the resonator or the filter.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

The electronic devices have different characteristics and advantages according to different operating principles. Among all of the electronic devices, a device that utilizes piezoelectric effect (or inverse piezoelectric effect) is an important type, and piezoelectric devices have a very wide range of applications. As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small size, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator mainly includes a "sandwich" structure composed of electrode-piezoelectric film-electrode, i.e., the piezoelectric material is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output through the piezoelectric effect.

With rapid development of communication technologies, an operating frequency of a filter needs to be continuously improved. For example, a frequency in a 5G communication band (sub-6G) ranges from 3 GHz to 6 GHz, which is higher than that of 4G or other communication technology. For the bulk acoustic wave resonator and filter, a high operating frequency indicates that a film thickness, especially a film thickness of an electrode, should be further reduced. However, a main negative effect caused by reducing of the film thickness of the electrode is increase in electrical loss, thereby decreasing a Q-value of a resonator, especially decreasing the Q-value at and near a series resonant frequency. Accordingly, performance of the bulk acoustic wave filter with the high operating frequency degrades greatly with a decreased Q-value of the bulk acoustic wave resonator.

In addition, when the resonator operates, it inevitably generates considerable thermal power, which can result a temperature rise of the resonator. Further, an ambient temperature also leads to temperature change of the resonator, especially in extreme (severe cold or high temperature) environment. However, the temperature change of the resonator may cause a series of corresponding changes in physical properties of its material, which thus leads to drift of a resonant frequency of the resonator. This frequency drift may cause performance of the resonator and performance of various electronic devices and apparatus using the resonator to degrade.

### SUMMARY

In order to alleviate or solve at least one aspect of above problems in the related art, the present disclosure is provided. In the present disclosure, a material layer with a temperature coefficient opposite to a temperature coefficient of a piezoelectric layer material is added to a sandwich structure of the resonator with an electrode having an air gap to compensate temperature drift, thereby suppressing performance degradation of the resonator caused by temperature change.

According to an aspect of an embodiment of the present disclosure, there is provided a bulk acoustic wave resonator. The bulk acoustic wave resonator includes a substrate, an acoustic mirror, a bottom electrode, a top electrode, a piezoelectric layer and a temperature compensation layer. The piezoelectric layer is provided between the bottom electrode and the top electrode. The acoustic mirror, the bottom electrode, the piezoelectric layer and the top electrode overlap with each other in a thickness direction of the resonator to form an overlapping region, which is an effective region of the resonator. The bottom electrode and/or the top electrode is an gap electrode, the gap electrode has at least one gap layer, and the gap layer is spaced at a distance from each of a top surface and a bottom surface of the gap electrode in a thickness direction of the gap electrode. The temperature compensation layer is formed in a sandwich structure of the resonator, the sandwich structure is composed of the bottom electrode, the piezoelectric layer, and the top electrode, and a material of the temperature compensation layer has a temperature coefficient opposite to a temperature coefficient of a material of the piezoelectric layer.

An embodiment of the present disclosure also relates to a filter that includes the bulk acoustic wave resonator described above.

An embodiment of the present disclosure also relates to an electronic device that includes the filter or the resonator described above.

### BRIEF DESCRIPTION OF DRAWINGS

The following description and drawings can facilitate to understand these and other features and advantages in various embodiments disclosed in the present disclosure. The same reference signs in the drawings always indicate the same components, and in which:

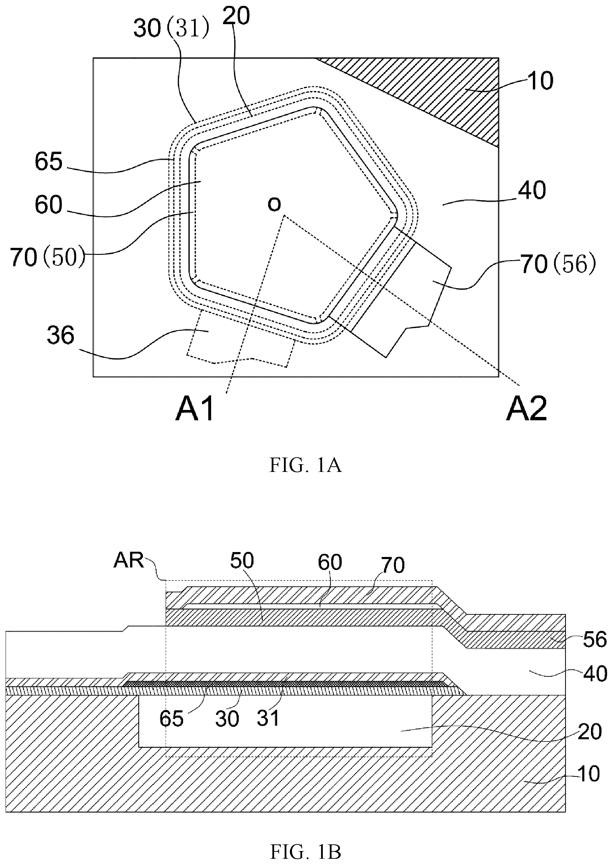

FIG. 1A is a schematic top view of a bulk acoustic wave resonator according to an exemplary embodiment of the present disclosure;
FIG. 1B is a schematic sectional view along A1OA2 in FIG.1A according to an exemplary embodiment of the present disclosure, in which a top electrode is provided with a gap layer and a bottom electrode is provided with a temperature compensation layer;

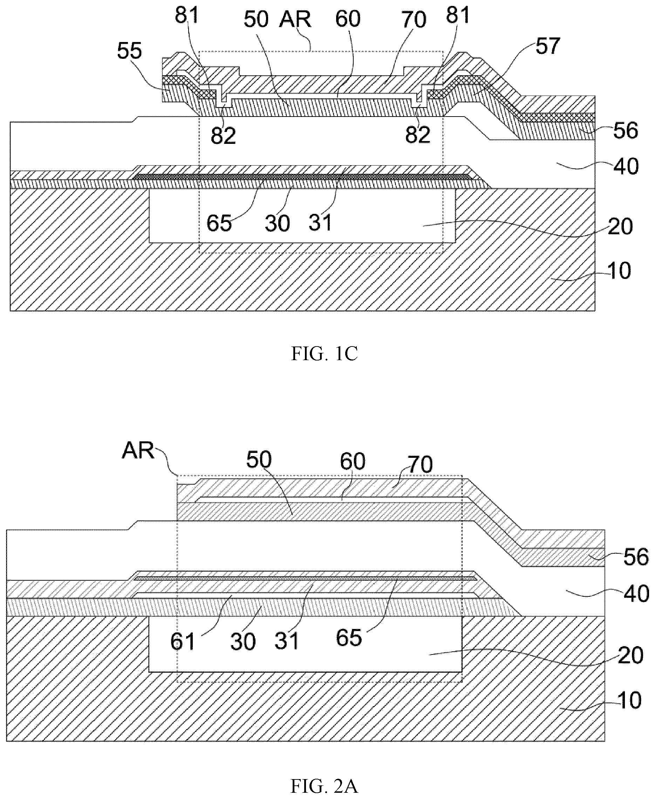

FIG. 1C is a schematic sectional view along A1OA2 in FIG.1A according to an exemplary embodiment of the present disclosure, in which a top electrode is provided with a gap layer, a bottom electrode is provided with a temperature compensation layer, and the top electrode is provided with a wing structure and a bridge structure;
FIG. 2A is a schematic sectional view of a bulk acoustic wave resonator according to an exemplary embodiment of the present disclosure, similar to the schematic sectional view along A1OA2 in FIG.1A, in which a top electrode and a bottom electrode are both provided with a gap layer, and the bottom electrode is provided with a temperature compensation layer;

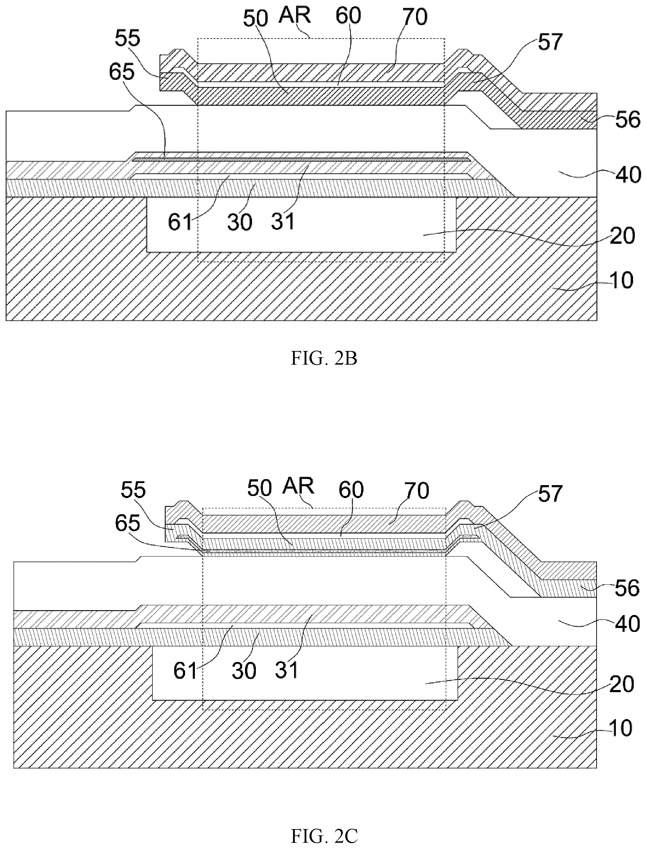

FIG. 2B is a schematic sectional view of a bulk acoustic wave resonator according to an exemplary embodiment of the present disclosure, similar to the schematic sectional view along A1OA2 in FIG.1A, in which a top electrode and a bottom electrode are both provided with a gap layer, the bottom electrode is provided with a temperature compensation layer, and the top electrode is provided with a wing structure and a bridge structure;
FIG. 2C is a schematic sectional view of a bulk acoustic wave resonator according to an exemplary embodiment of the present disclosure, similar to the schematic sectional view along A1OA2 in FIG.1A, in which a top electrode and a bottom electrode are both provided with a gap layer, the top electrode is provided with a temperature compensation layer, and the top electrode is provided with a wing structure and a bridge structure;

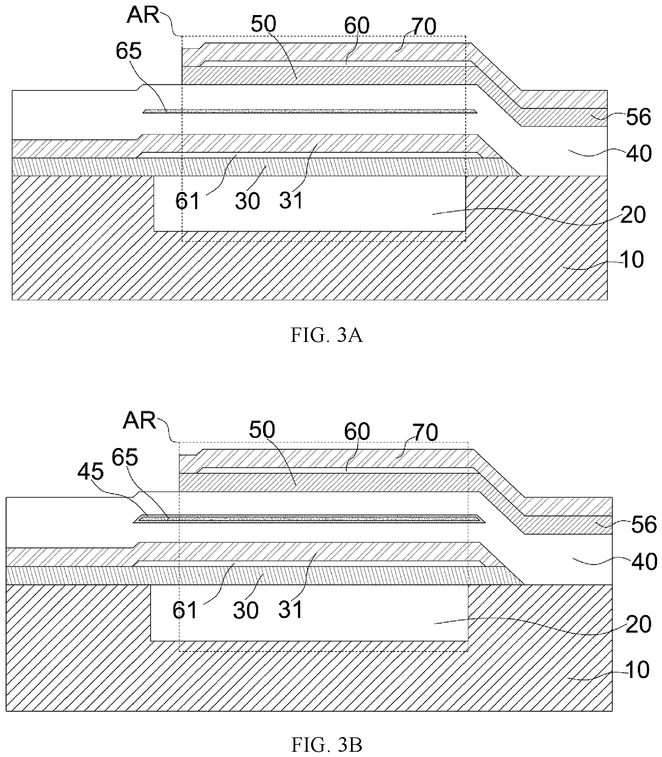

FIG. 3A is a schematic sectional view of a bulk acoustic wave resonator according to an exemplary embodiment of the present disclosure, similar to the schematic sectional view along A1OA2 in FIG.1A, in which a top electrode and a bottom electrode are both provided with a gap layer and a temperature compensation layer is provided in a piezoelectric layer;
FIG. 3B is a schematic sectional view of a bulk acoustic wave resonator according to an exemplary embodiment of the present disclosure, similar to the schematic sectional view along A1OA2 in FIG.1A, in which a top electrode and a bottom electrode are both provided with a gap layer, a temperature compensation layer is provided in a piezoelectric layer, and the temperature compensation layer is coated with a shielding metal layer; and

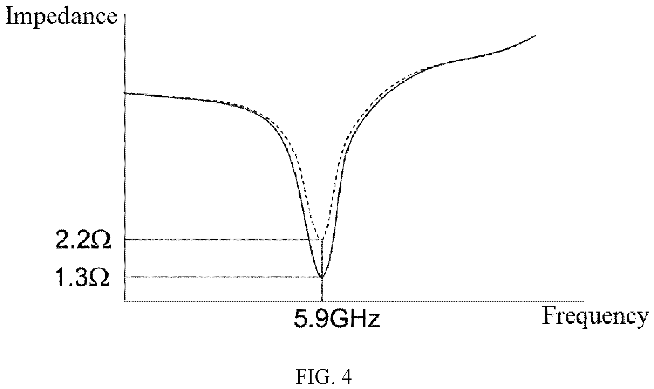

FIG. 4 is a frequency-impedance graph of a bulk acoustic wave resonator, in which a solid line corresponds to the bulk acoustic wave resonator in FIG.1B, and a dotted line corresponds to a bulk acoustic wave resonator without a gap layer in the electrode.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

FIG. 1A is a schematic top view of a resonator structure according to an exemplary embodiment of the present disclosure, and FIG.1B is a sectional view of FIG. 1A along a folding line A1OA2 in FIG.1A. Reference numbers are as follows.
10: Substrate, which may be made of a material such as monocrystalline silicon, gallium arsenide, sapphire, and quartz.
20: Acoustic mirror, which may be an air cavity, a Bragg reflection layer, or other equivalent acoustic reflection structures.
30: First bottom electrode, which may be made of a material such as molybdenum, ruthenium, gold, aluminum, magnesium, tungsten, copper, titanium, iridium, osmium, chromium, or composite or alloys thereof.
31: Second bottom electrode, which may be made of a material selected from a same range as that of the first bottom electrode 30, but a specific material is not necessarily the same as that of the first bottom electrode 30.
36: Electrode pin, of which a material is the same as that of the first bottom electrode.
40: Piezoelectric film layer, which may be made of a material such as aluminum nitride (AlN), zinc oxide (ZnO), lead zirconate titanate (PZT), lithium niobate (LiNbO₃), quartz, potassium niobate (KNbO₃), or lithium tantalate (LiTaO₃), or the like, and may also contain the above materials doped with a certain atomic ratio of rare earth element.
50: First top electrode, which may be made of a material selected from molybdenum, ruthenium, gold, aluminum, magnesium, tungsten, copper, titanium, iridium, osmium, chromium, or composite or alloys thereof.
56: Electrode pin, of which a material is the same as that of the first top electrode.
60: Air gap, which is formed in the top electrode and located between the first top electrode 50 and the second top electrode 70.
65: Temperature compensation layer, of which a temperature coefficient of a material is required to be opposite to that of a material used to form a specifically selected piezoelectric layer. For example, when the piezoelectric layer is made of aluminum nitride, the temperature compensation layer has a positive temperature coefficient and the material of the temperature compensation layer is silicon dioxide.
70: Second bottom electrode, of which a material is selected from the same range as that of the first top electrode 50, but a specific material is not necessarily the same as that of the first top electrode 50.

When the resonator operates, an alternating electric field is applied to the piezoelectric layer 40 through the electrodes. Since acoustic and electrical energy are coupled and transform mutually, a current flows through the electrodes. The top electrode of this embodiment has a dual-layer electrode parallel structure such that electrical loss of the resonator can be effectively reduced. The piezoelectric layer generates acoustic waves under excitation of the alternating electric field. When the acoustic waves are conducted upwards to an interface between the air gap 60 in the top electrode and the electrode layer 50, energy of the acoustic waves is reflected back to the piezoelectric layer 40 since acoustic impedances of the air and the electrode are greatly mismatched. However, the energy of the acoustic waves cannot enter the electrode layer 70. On the one hand, the electrode structure with the air gap in the present disclosure significantly reduces the electrical loss of the resonator, which represents an increased Q-value at and near the series resonant frequency. As shown in FIG. 4, when the resonator employs the electrode structure with the air gap as shown in FIG. 1B, an impedance at the series resonant frequency (5.9 GHz) and its adjacent region decreases from 2.2 ohms to 1.3 ohms (without considering the temperature compensation layer). On the other hand, the air gap functions to acoustically isolate the top electrode 70, thus substantially avoiding negative influence of the electrode layer 70, such as change of the resonant frequency and electromechanical coupling coefficient, on performance of the resonator.

A height of the air gap is in a range of 50 Å to 10000 Å. The height of the air gap is generally greater than a typical amplitude of the resonator (about 10 nm). For example, the height of the air gap is in a range of 100 Å to 5000 Å. Such the height range facilitates acoustic energy decoupling between the top electrode 70 and a resonant cavity when the resonator operates at a high power. The resonant cavity is a composite structure composed of the top electrode 50, the piezoelectric layer 40, and the bottom electrode 30 in this embodiment.

It should be noted that the air gap constitutes a gap layer, but in the present disclosure, the gap layer may be a vacuum gap layer or a gap layer filled with other gas medium, in addition to the air gap layer.

In addition, the temperature compensation layer 65 in FIG.1B laterally extends beyond an effective acoustic region AR, and may further extend beyond a region of the acoustic mirror 20.

FIG. 1C is a schematic sectional view along A1OA2 in FIG.1A according to an exemplary embodiment of the present disclosure, in which the top electrode has the gap layer, the bottom electrode has the temperature compensation layer, and the top electrode has a wing structure 55 and a bridge structure 57. In FIG.1C, the top electrode further includes a convex structure 81 and a concave structure 82. The wing structure, the bridge structure, the convex structure and the concave structure constitute an acoustic impedance mismatch structure of the resonator.

In other embodiments shown in the present disclosure, an acoustic impedance mismatch structure may be provided, which includes one or more of the wing structure, the bridge structure, the convex structure, and the concave structure. FIG. 2A is a schematic sectional view of a bulk acoustic wave resonator according to an exemplary embodiment of the present disclosure, similar to the schematic sectional view along A1OA2 in FIG.1A, in which a top electrode and a bottom electrode have both a gap layer, and the bottom electrode has a temperature compensation layer. In FIG.2A, a gap layer 61 is formed between a first bottom electrode 30 and a second bottom electrode 31, while a temperature compensation layer 65 is located in the second bottom electrode 31. As shown in FIG.2A, a distance between the temperature compensation layer 65 and a piezoelectric layer in a thickness direction is less than a distance between the temperature compensation layer and the gap layer.

FIG. 2B is a schematic sectional view of a bulk acoustic wave resonator according to an exemplary embodiment of the present disclosure, similar to the schematic sectional view along A1OA2 in FIG. 1A, in which a top electrode and a bottom electrode have both a gap layer and the bottom electrode has a temperature compensation layer 65, but unlike the structure of FIG.2A, the top electrode has a wing structure 55 and a bridge structure 57 in FIG. 2B.

FIG. 2C is a schematic sectional view of a bulk acoustic resonator wave according to an exemplary embodiment of the present disclosure, similar to the schematic sectional view along A1OA2 in FIG. 1A, in which a top electrode and a bottom electrode have both a gap layer (a gap layer 60 is arranged between a first top electrode 50 and a second top electrode 70 of the top electrode), a temperature compensation layer 65 is formed in the first top electrode 50, and the top electrode further has a wing structure 55 and a bridge structure 57. As shown in FIG.2C, a distance between the temperature compensation layer 65 and the piezoelectric layer in a thickness direction is less than a distance between the temperature compensation layer and the gap layer.

It should be noted that a position of the temperature compensation layer is not limited to be in the electrode at one side, and the temperature compensation layer may be arranged in the electrodes at both sides.

In addition to the temperature compensation layer in the electrode, the piezoelectric layer can be provided with a temperature compensation layer.

FIG. 3A is a schematic sectional view of a bulk acoustic wave resonator according to an exemplary embodiment of the present disclosure, similar to the schematic sectional view along A1OA2 in FIG. 1A, in which a top electrode and a bottom electrode have both a gap layer and a temperature compensation layer 65 is provided in a piezoelectric layer 40.

FIG. 3B is a schematic sectional view of a bulk acoustic wave resonator according to an exemplary embodiment of the present disclosure, similar to the schematic sectional view along A1OA2 in FIG. 1A, in which a top electrode and a bottom electrode have both a gap layer, a temperature compensation layer 65 is provided in a piezoelectric layer 40. Further, the temperature compensation layer is coated with a shielding metal layer 45 to shield an electric field, so that the temperature compensation layer 65 is not affected by the electric field, thereby reducing negative influence on performance of the resonator caused by a series capacitance of the resonator, which is formed by the temperature compensation layer used as a dielectric layer.

In the above embodiments of the present disclosure, the substrate 10 includes the acoustic cavity 20, and an overlapping region of the acoustic cavity, the bottom electrode, the piezoelectric layer and the top electrode in the thickness direction of the resonator constitutes the effective region of the resonator. However, the present disclosure is not limited thereto. For example, when the bottom electrode is a gap electrode, the gap layer in the bottom electrode can be used as an acoustic mirror structure. In this case, an overlapping region of the top electrode, the bottom electrode, the piezoelectric layer and the gap layer in the thickness direction of the resonator constitutes the effective region of the resonator, in which the acoustic cavity 20 can be omitted. Alternatively, the acoustic cavity 20 can be reserved and the gap layer completely covers the acoustic cavity in a top view of the resonator.

In addition, in the present disclosure, when the acoustic impedance mismatch structure includes the wing structure and the bridge structure, a boundary of the effective region of the resonator is defined by inner edges of the wing structure and the bridge structure.

In the present disclosure, a gap layer is formed in the top electrode and/or the bottom electrode of the bulk acoustic wave resonator. The air gap in the electrode effectively reflects acoustic waves and greatly reduces energy of the acoustic waves entering an additional electrode on a side away from the piezoelectric film (or the piezoelectric layer), so as to effectively suppress or eliminate negative effects of the additional electrode due to its participation in acoustic vibration. In addition, two layers (or multi-layers) of electrodes enclosing the air gap form a parallel circuit structure, which effectively reduces the electrical loss of the resonator and improve the Q-value of the resonator, especially the Q-value at and near the series resonant frequency.

Therefore, the additional electrode is acoustically decoupled from the resonator cavity due to the air gap, since most of the acoustic waves are reflected back to the resonator cavity at the air gap, instead of entering the additional electrode. The existence and parameter changes of the additional electrode do not affect other key parameters (such as, the resonant frequency and the electromechanical coupling coefficient) of the resonator except for the Q-value.

Compared with a structure in which the air gap is located between the piezoelectric layer and the electrode, in the present disclosure, the parasitic series capacitance produced by the air gap is avoided, and the electromechanical coupling coefficient kt² of the resonator does not degrade. Compared with a structure in which the temperature compensation interlayer (such as of silicon dioxide) is located in a middle of two layers of electrodes, the air gap or vacuum gap of the present disclosure causes the resonant frequency of the resonator unchanged, other key parameters (such as, the Q-value and the electromechanical coupling coefficient) do not degrade, and the Q-value at and near the series resonant frequency is improved.

In addition, in the present disclosure, the temperature compensation layer is provided such that the resonator structure according to the present disclosure reduces the impedance of the resonator and effectively suppresses frequency drift caused by temperature change.

A numerical range mentioned in the present disclosure encompass not only end values, but also a median value or other values between the end values, all of which are within the scope of the present disclosure.

As can be understood by those skilled in the art, the bulk acoustic wave resonator according to the present disclosure can be configured to form a filter.

Based on the above, the present disclosure provides following technical solutions.
1. A bulk acoustic wave resonator includes:
   a substrate;
   an acoustic mirror;
   a bottom electrode;
   a top electrode; and
   a piezoelectric layer provided between the bottom electrode and the top electrode,
   wherein
   the acoustic mirror, the bottom electrode, the piezoelectric layer and the top electrode overlap with each other in a thickness direction of the resonator to form an overlapping region, which is an effective region of the resonator;
   the bottom electrode and/or the top electrode is a gap electrode, the gap electrode has at least one gap layer, and the gap layer is spaced a distance from each of a top surface and a bottom surface of the gap electrode in a thickness direction of the gap electrode; and
   a temperature compensation layer is formed in a sandwich structure of the resonator, the sandwich structure is composed of the bottom electrode, the piezoelectric layer, and the top electrode, and a material of the temperature compensation layer has a temperature coefficient opposite to a temperature coefficient of a material of the piezoelectric layer.
2. The bulk acoustic wave resonator according to 1, wherein
   the temperature compensation layer is arranged in at least one of the bottom electrode and the top electrode.
3. The bulk acoustic wave resonator according to 2, wherein
   the temperature compensation layer includes a gap electrode temperature compensation layer arranged in the gap electrode.
4. The bulk acoustic wave resonator according to 3, wherein
   the gap electrode includes a first electrode layer and a second electrode layer that are electrically connected with each other, the first electrode layer is arranged closer to the piezoelectric layer than the second electrode layer, and the gap layer is arranged between the first electrode layer and the second electrode layer; and
   the temperature compensation layer is arranged in the first electrode layer of the gap electrode.
5. The bulk acoustic wave resonator according to 4, wherein
   in the thickness direction of the resonator, a distance between the gap electrode temperature compensation layer and the piezoelectric layer is less than a distance between the gap electrode temperature compensation layer and the gap layer.
6. The bulk acoustic wave resonator according to 4 or 5, wherein
   the gap electrode temperature compensation layer is arranged parallel to the gap layer.
7. The bulk acoustic wave resonator according to 1, wherein
   the temperature compensation layer includes a piezoelectric layer temperature compensation layer arranged in the piezoelectric layer.
8. The bulk acoustic wave resonator according to 7 further includes:
   a shielding metal layer wrapped around the piezoelectric layer temperature compensation layer.
9. The bulk acoustic wave resonator according to 1, wherein
   the gap electrode temperature compensation layer extends laterally over the entire effective region of the resonator.
10. The bulk acoustic wave resonator according to 1, wherein
   the bottom electrode is the gap electrode, the gap layer is configured to be the acoustic mirror, and the top electrode, the bottom electrode, the piezoelectric layer and the gap layer overlap with each other in the thickness direction of the resonator to form an overlapping region, which is the effective region of the resonator.
11. The bulk acoustic wave resonator according to 10 further includes:
   an acoustic cavity formed in the substrate, the gap layer completely covering the acoustic cavity in a top view of the resonator.
12. The bulk acoustic wave resonator according to 1, wherein
   the top electrode is the gap electrode; and
   the top electrode, the piezoelectric layer, the bottom electrode and the acoustic mirror overlap with each other in the thickness direction of the resonator to form an overlapping region, which is the effective region of the resonator.
13. The bulk acoustic wave resonator according to 1, wherein
   the top electrode is provided with an acoustic impedance mismatch structure at an edge of the effective region.
14. The bulk acoustic wave resonator according to any one of 1 to 13, wherein
   the gap layer is an air gap layer or a vacuum gap layer.
15. The bulk acoustic wave resonator according to 14, wherein
   the gap layer has a thickness in a range of 50 Å to 10000 Å.
16. The bulk acoustic wave resonator according to 14, wherein
   the gap layer has a thickness in a range of 100 Å to 5000 Å.
17. A filter includes the bulk acoustic wave resonator according to any one of 1 to 16.
18. An electronic device includes the filter according to 17 or the bulk acoustic wave resonator according to any one of 1 to 16.

Although the embodiments of the present disclosure have been shown and described, it can be understood by those skilled in the art that changes can be made to these embodiments without departing from the principle and spirit of the present disclosure, and the scope of the present disclosure is defined by appended claims and their equivalents.

## Claims

1. A bulk acoustic wave resonator, comprising:
a substrate;
an acoustic mirror;
a bottom electrode;
a top electrode; and
a piezoelectric layer provided between the bottom electrode and the top electrode,
wherein the acoustic mirror, the bottom electrode, the piezoelectric layer and the top electrode overlap with each other in a thickness direction of the resonator to form an overlapping region, which is an effective region of the resonator;
wherein the bottom electrode and/or the top electrode is a gap electrode, the gap electrode has at least one gap layer, and the at least one gap layer is spaced a distance from each of a top surface and a bottom surface of the gap electrode in a thickness direction of the gap electrode; and
wherein a temperature compensation layer is formed in a sandwich structure of the resonator, the sandwich structure is composed of the bottom electrode, the piezoelectric layer, and the top electrode, and a material of the temperature compensation layer has a temperature coefficient opposite to a temperature coefficient of a material of the piezoelectric layer.

2. The bulk acoustic wave resonator according to claim 1, wherein the temperature compensation layer is arranged in at least one of the bottom electrode and the top electrode.

3. The bulk acoustic wave resonator according to claim 2, wherein the temperature compensation layer comprises a gap electrode temperature compensation layer arranged in the gap electrode.

4. The bulk acoustic wave resonator according to claim 3, wherein the gap electrode comprises a first electrode layer and a second electrode layer that are electrically connected with each other, the first electrode layer is arranged closer to the piezoelectric layer than the second electrode layer, and the at least one gap layer is arranged between the first electrode layer and the second electrode layer; and
the temperature compensation layer is arranged in the first electrode layer of the gap electrode.

5. The bulk acoustic wave resonator according to claim 4, wherein in the thickness direction of the resonator, a distance between the gap electrode temperature compensation layer and the piezoelectric layer is less than a distance between the gap electrode temperature compensation layer and the at least one gap layer.

6. The bulk acoustic wave resonator according to claim 4 or 5, wherein the gap electrode temperature compensation layer is arranged parallel to the at least one gap layer.

7. The bulk acoustic wave resonator according to claim 1, wherein the temperature compensation layer comprises a piezoelectric layer temperature compensation layer arranged in the piezoelectric layer.

8. The bulk acoustic wave resonator according to claims 7, further comprising:
a shielding metal layer wrapped around the piezoelectric layer temperature compensation layer.

9. The bulk acoustic wave resonator according to claim 1, wherein the gap electrode temperature compensation layer extends laterally over the entire effective region of the resonator.

10. The bulk acoustic wave resonator according to claim 1, wherein the bottom electrode is the gap electrode; and
the at least one gap layer is configured to be the acoustic mirror, and the top electrode, the bottom electrode, the piezoelectric layer and the at least one gap layer overlap with each other in the thickness direction of the resonator to form an overlapping region, which is the effective region of the resonator.

11. The bulk acoustic wave resonator according to claim 10, further comprising:
an acoustic cavity formed in the substrate, the at least one gap layer completely covering the acoustic cavity in a top view of the resonator.

12. The bulk acoustic wave resonator according to claim 1, wherein the top electrode is the gap electrode; and
the top electrode, the piezoelectric layer, the bottom electrode and the acoustic mirror overlap with each other in the thickness direction of the resonator to form an overlapping region, which is the effective region of the resonator.

13. The bulk acoustic wave resonator according to claim 1, wherein the top electrode is provided with an acoustic impedance mismatch structure at an edge of the effective region.

14. The bulk acoustic wave resonator according to any one of claims 1 to 13, wherein the at least one gap layer is an air gap layer or a vacuum gap layer.

15. The bulk acoustic wave resonator according to claim 14, wherein the at least one gap layer has a thickness in a range of 50 Å to 10000 Å.

16. The bulk acoustic wave resonator according to claim 14, wherein the at least one gap layer has a thickness in a range of 100 Å to 5000 Å.

17. A filter comprising the bulk acoustic wave resonator according to any one of claims 1 to 16.

18. An electronic device comprising the filter according to claim 17 or the bulk acoustic wave resonator according to any one of claims 1 to 16.
